Europäisches Patentamt

European Patent Office

Office européen des brevets

(11) Publication number: 0 219 200
A2

# EUROPEAN PATENT APPLICATION

(21) Application number: 86306092.7

(22) Date of filing: 06.08.86

(51) Int. Cl.⁴: G03F 3/10

(30) Priority: 04.10.85 GB 8524483

(43) Date of publication of application:
22.04.87 Bulletin 87/17

(84) Designated Contracting States:
AT BE CH DE FR GB IT LI LU NL SE

(71) Applicant: Foilwraps Flexible Packaging Limited
Ross Road
Weedon Road Estate Northampton NN5 5AX(GB)

(72) Inventor: Chudley, Robin William
No. 1 Scotia Close
Brackmills Estate Northampton NN4 OPH(GB)

(74) Representative: Gallafent, Richard John et al
GALLAFENT & CO. 8 Staple Inn
London WCIV 7QH.(GB)

(54) Control of intaglio printing.

(57) By using the power and controllability of computer-controlled gravure cylinder-making, and by careful coordination of this with the manufacture of lithographic proof prints via scanning and platemaking, it is possible to ensure that a litho proof looks exactly the same as the final gravure printed product. Working in this way avoids the substantial inconvenience and cost of final proofing "on machine", and the risks of having to remake one or more gravure cylinders. This approach to proofing for gravure work is controlled, in accordance with the invention, by the use of a test strip or area which is subjected to processing in parallel to the image. Use of a test strip enables gravure cylinder engraving to be specified, checked and accurately monitored by a printer without needing to place the cylinder in a printing press. Furthermore, when the cylinders are on press, final adjustments before a run can be made easier and more rapidly using the test strip or area and a narrow format stock.

## Control of intaglio printing

This invention relates to the control of intaglio printing, particularly gravure printing, and most particularly to methods of controlling the preparation of cylinders for gravure printing to enable the desired printed results to be achieved.

In gravure printing, printing ink is applied in recesses in the surface of a copper-coated steel roller which is chromium plated. Manufacturing such rollers is time-consuming and expensive, as it involves forming a relief pattern on the surface of the roller, which starts off with a perfectly smooth outer surface, by etching, or by some other form of erosive operation. The gravure cylinders are made in sets where multicolour printing is desired, and their manufacture and storage requires substantial expenditure of time and money and space. Nevertheless, gravure printing has the major advantage that the cylinders, being chromium plated, hardly wear out at all, so the system is very much favoured for long printing runs, and particularly for print runs where print consistency is of the greatest importance. It is, for example, very important to ensure that plastics packages around foodstuffs are all printed precisely the same colour, as if they are not, variance of colour is seen as discolouration for certain of the packages, which are therefore assumed by the consumer to be old and are accordingly not selected for purchase.

In normal practice, it is customary for the customer to see and approve a sample of what the finished printing will be like before commencing a printing run, and this is particularly important and insisted on by most customers for gravure printing, especially due to the high cost of the long runs involved. Up to now it has been necessary to set up the printing machine with the actual cylinders to be used, and to run it before such a sample could be produced, since there has been no satisfactory way of simulating production conditions accurately off the machine, and thus of producing a proof which would match the final product.

Although gravure cylinder makers have, in the past, provided proofs in the form of Chromalin or litho prints from the artwork, it is recognised that these are only guides, and are unsatisfactory for presentation to the customer for approval, particularly where the final quality of the printing is important. Further, since in the past cylinders have mainly been etched by chemical methods, the design of each cylinder has usually been only an approximation of what was actually required and much adjustment of machine controls, ink viscosity, etc., had to be made before a result satisfactory to the customer could be achieved. Often, this proved to be impossible until one or more of the cylinders had been taken off the gravure press and adjusted or even re-made.

This approach to proofing is thus extremely expensive in machine time and wasted materials. Also, since gravure cylinders are usually made by specialist companies away from the printing works, much time, even several weeks, may elapse before the customer can be shown the press producing satisfactory material which can be approved in order to enable the print run proper to begin.

With the advent of computer-controlled mechanical engraving of cylinders, it is now possible for gravure cylinder makers to produce gravure cylinders in much more reproducible and controlled fashion. However, in terms of the final proof and approval of it, it has, up till now, been necessary still to mount the cylinders on a printing machine to prove that they have been prepared accurately and to produce the samples needed by the customer for proofing and approval.

Attempts have been made in the past to overcome the difficulties referred to above. United States Patent Specification 4324179 and British Patent Specification 1561566 both describe the problem of producing an accurate proof, and suggest solutions whereby a lithographic proof may be made to match the result which is finally produced using gravure cylinders. However, while both of these specifications disclose that two visually matching printed products may be made by different printing methods, they fail to give any practical guidance to the printer as to how to achieve the matching of final print to approved proof with certainty.

Control of the overall processing may be much improved by the use of computer controlled numerical methods such as are described in British Patent Specification 2022512A and in the publication "Electronic offset/gravure conversion by Helio-Klischograph K201/202 -Application Manual" published by Dr. Ing Rudolf Hell, of D2300 Kiel 14, West Germany. Using such techniques it is theoretically possible, by the careful use of lithographic proofing techniques, conversion data from litho to gravure and by the careful control of gravure cylinder manufacturing techniques, to produce a litho print on a piece of stock material to be printed, which simulates a gravure press proof, which litho print can be presented to a custoxer for approval and, when approved, can be committed to gravure cylinders. Such cylinders can in due course be mounted on the machine and, possibly with minor colour adjustment only, they will then produce an accurate match to the approved proof print.

Working in such a way, the overall method of manufacturing printed material from original artwork by an intaglio printing method on to desired stock includes the following sequence of operations:

1. analysing the artwork into a plurality of separations each of which is reduced to a monochrome image on photographic film,

2. producing from each monochrome image a litho plate corresponding thereto,

3. using the plurality of litho plates, producing a multicolour print using a suitable e.g. flatbed litho proofing press, conveniently on the stock,

4. repeating steps 1 to 3 if necessary until the multicolour print is as desired,

5. taking the set of monochrome images on photographic film, or a set of monochrome images on photographic film corresponding thereto but adjusted relative thereto by given conversion factors, as reference material and using such reference material to manufacture a set of intaglio printing masters, e.g. gravure cylinders, one corresponding to each separation of the set, using a computer controlled production method, if necessary using conversion factors in such method to control the production of the printing master,

6. mounting the intaglio printing master cylinders in a printing press and

7. printing the stock using the printing press, the master cylinders and appropriate inks.

In accordance with the present invention, the control of such manufacture, particularly step 5 thereof, is effected by the use of a test strip in juxtaposition to the desired image areas on each cylinder in the set.

Test strips are known in various printing areas, but they are used predominantly for checking printed material. We have found that if a test strip is used in juxtaposition to the desired image areas on each cylinder in the set, the test strip may be used to monitor and control the actual production of the intaglio master cylinders themselves, such as gravure cylinders. The use of a test strip in this way is new and brings with it very substantial practical advantages. In particular, it enables the printer to specify to the intaglio master cylinder manufacturer, normally the gravure cylinder engraver, exactly what is needed and the engraver can check this without difficulty as engraving proceeds, thus saving substantial engraving time as well.

It is particularly useful, when practising the invention, to arrange the test strip (or strips) to lie at one end or both ends of a gravure cylinder, preferably at both ends. This enables checking to take place that both ends of the cylinder are properly engraved and, when the cylinders are mounted on press, it enables press adjustments to take place using narrow stock fed to one or both sides of the press prior to feeding full-width stock into the press for a final printing of the desired images.

The test strip is preferably subjected to identical processing in parallel with that undergone by the monochrome images on film, as this enables process quality control to be checked easily at each stage. Preferably the test strip is included with the monochrome images on the films before the proofing, after step 1 above, so that the test strip is likewise processed and images corresponding to component portions of the test strip are finally produced. This is of particular value where the stock to be printed on is expensive, as it enables very little stock to be wasted if narrow format stock is used first of all to print the test strip, followed by printing only on the wide format stock once the test strip has been printed satisfactorily.

It is found that, operating in this way, it is possible to produce printing results on the press which correspond exactly to the proof print which has been approved. It is of course possible still to make minor adjustments on machine, as done normally with gravure printing, but using the method of the invention the adjustments are always minor, and can be effected speedily and simply to provide the desired results. The risk that one or more cylinders needs to be remade is removed. The adjustments are facilitated by the use of the test strip on the intaglio masters on the press. The actual image areas can be ignored by the printer, secure in the knowledge that once the test strip area is printing as desired, the image areas will print as desired.

It will be seen from the above that when using standard gravure printing there are two alternative approaches which may be used when carrying out the process of the invention. The first alternative is to use the set of monochrome separations on photographic film as the input material for the computer controlled engraving machine. In those circumstances, the computer controlled engraving machine must also have fed into it the relevant conversion data to ensure that the final desired result is achieved. Simple testing will enable such conversion data to be established, and this conversion data may be used appropriately to modify the programme executed by the computer controlled engraving machine.

Alternatively, instead of introducing the conversion factors at that stage, they can be taken into account when doing the original scan of the artwork, the analysis then producing two sets of monochrome images on photographic film, one set of which is used to make the litho plates to make the litho proof, and the other set of which, adjusted using modifications to the programming for the scanner, can then be used straightforwardly as input for the computer controlled engraving machine, in which case the standard programme of the computer controlled engraving machine may be allowed simply to operate. Using either route, the test strip enables standardisation to be effected, and checking test strip areas ensures that the finally produced cylinders produce a final print which looks like the litho print. The individual conversion factors may of course vary in detail from one set of types of machine to another, and with varying operational conditions from plant to plant, but it is straightforward, using standard source material and appropriate test strips, for example Brunner system test strips as used in four-colour process printing, and appropriate testing equipment or the quadrant conversion method as published in "The Electronic Offset/Gravure Conversion by Helio-Klishograph K20l/202 Application Manual published by Dr. Ing Rudolph Hell, to determine the relevant conversion requirements for any given set of machines and plant. It is on occasion laborious, particularly having regard to the different screen dot shapes and gravure cell formations which are used to avoid colour drift and screen clash/moiré effects, but it is straightforward.

Engraved cylinders including engraved test strips produced in parallel with the image areas are new articles in their own right and constitute a further and valuable feature of this invention.

Once the appropriate conversion factors have been established, they may naturally be stored for future use conveniently on a computer compatible storage means such as a floppy disc or eprom and they may be used either to control production of a second set of monochrome separations during step I above or to control the mechanical engraving machine used in step 5 above.

The invention is not restricted to classical gravure printing operations. It may be applied to offset gravure printing processes and to combinations of intaglio printing processes with other types, e.g. flexographic.

In all these cases, the use of a test strip according to the invention enables the printer himself to establish the exact requirements for engraving the printing cylinder and to specify these requirements to the cylinder maker, so that his instructions to the cylinder maker are precise in terms of engraving depth, cell width and stylus angle, cell formation and gradation. The strip constitutes a control which is engraved on the cylinder which can be used to confirm that the printer's instructions have been truly carried out. Working this way enables acceptance (or rejection) of cylinders by the printer without needing to mount the cylinders in a press and make some proof runs.

A further advantage of the method of the present invention is that it enables the production, at an early stage, of usable samples which will accurately match the final product many weeks before the final product itself can be manufactured (due to the substantial length of time which gravure cylinder manufacture takes). This is of particular value in product packaging, where the proofs can be used as samples of the final product, e.g. to produce market research material and pre-launch publicity material.

Commercially available apparatus and machinery may be used without difficulty to put the invention into effect. We have found that very satisfactory results may be achieved using a Hell Scanner type C.P. 340 to produce the various monochrome images, using a Korex chilled bed litho proofing press to produce the litho proofs and using a Hell GmbH Helio-Klischographic type K. 303 for engraving the set of gravure cylinders The final printed product which matches the proofs was printed by offset gravure on a Carraro Eurocoraflex C.I. press. The test strip used was a linear stepwedge, and checking the engraved linear stepwedge on the cylinders, to ensure that the engraving had been carried out correctly, was done using a Cellscan cylinder microscope.

## Claims

I. A method of manufacturing intaglio printed material from original artwork by printing using intaglio master cylinders on to desired stock, which includes the following sequence of operations:

I. analysing the artwork into a plurality of separations each of which is reduced to a monochrome image on photographic film,

2. producing from each monochrome image a litho plate corresponding thereto,

3. using the plurality of litho plates, producing a multicolour print using a suitable litho proofing press,

4. repeating steps I to 3 if necessary until the multicolour print is as desired,

5. taking the set of monochrome images on photographic film, or a set of monochrome images on photographic film corresponding thereto but adjusted relative thereto by given conversion factors, as reference material and using such reference material to manufacture a set of intaglio master cylinders corresponding to each separation of the set, using computer controlled techniques, if necessary using conversion factors to control the operation thereof,

6. mounting the set of intaglio master cylinders in a printing press and

7. printing the stock using the printing press, the master cylinders and appropriate inks,

characterised in that, after step I, the monochrome image is supplemented by a test strip or area, and that the sequence of operations is carried out on both the monochrome image and the test strip or area, and the test strip or area is monitored to provide overall control of the manufacture.

2. A method according to claim I wherein the final printing step 7 is carried out initially using the portions of the master cylinders corresponding to the test strip or area, and subsequently, following final adjustments, on the portions of the master cylinders corresponding to the artwork.

3. A method according to claim I or 2 wherein the printing step 7 is carried out by offset gravure printing.

4. A method according to any one of claims I to 3 wherein, after step 5 but before step 6, the masters are checked optically by inspection of the test strip or area, to ensure that the instructions relating to manufacturing the master cylinders have been followed.

5. A gravure printing cylinder having intermediate its ends an engraved image area corresponding to an image it is desired to print and, at one or both ends, an engraved test strip or area formed by the same engraving method and under the same conditions as the engraved image area.